# EUROPÄISCHE PATENTSCHRIFT

(11) **EP 4 282 034 B1**
(45) Veröffentlichungstag und Bekanntmachung des Hinweises auf die Patenterteilung: **09.07.2025**
(21) Anmeldenummer: 22706510.9
(22) Anmeldetag: 01.02.2022
(51) Int. Cl.: H01R 12/58, H05K 3/32, H01R 43/20, H05K 1/02

(54) **STROMVERBINDUNGSVORRICHTUNG FÜR LEITERPLATTEN UND VERFAHREN ZUR MONTAGE EINER DERARTIGEN STROMVERBINDUNGSVORRICHTUNG AN EINER LEITERPLATTE**
POWER CONNECTION DEVICE FOR CIRCUIT BOARDS AND METHOD OF MOUNTING SUCH A POWER CONNECTION DEVICE ON A CIRCUIT BOARD
DISPOSITIF CONNECTEUR D'ALIMENTATION POUR CARTES DE CIRCUIT IMPRIMÉ ET PROCÉDÉ DE MONTAGE D'UN TEL DISPOSITIF CONNECTEUR D'ALIMENTATION SUR UNE CARTE DE CIRCUIT IMPRIMÉ

(30) Priorität: 01.02.2021 EP 21154567
(43) Veröffentlichungstag der Anmeldung: 29.11.2023
(73) Patentinhaber: FRONIUS INTERNATIONAL GmbH, 4643 Pettenbach (AT)
(72) Erfinder: SPIESBERGER, Alfred, 4643 Pettenbach (AT)
(74) Vertreter: Bratovic, Nino Maria
(86) Internationale Anmeldenummer: PCT/EP2022/052262
(87) Internationale Veröffentlichungsnummer: WO 2022/162231

(56) Entgegenhaltungen:
- EP-A1- 3 435 490

## Beschreibung

Die Erfindung betrifft eine Stromverbindungsvorrichtung für eine Leiterplatte sowie ein Verfahren zur Montage einer derartigen Stromverbindungsvorrichtung an einer Leiterplatte.

Eine Leiterplatte (englisch: Printed Circuit Board, PCB) dient als Träger für elektronische Bauteile. Eine Leiterplatte kann mit elektronischen Bauteilen, insbesondere auch mit elektronischen Leistungsbauteilen, bestückt werden.

Leiterplatten bestehen üblicherweise aus einem elektrisch isolierenden Material mit elektrisch leitenden Leiterbahnen. Als isolierendes Material einer Leiterplatte wird üblicherweise ein faserverstärkter Kunststoff oder Hartpapier verwendet. Die elektrisch leitfähigen Leiterbahnen werden in vielen Fällen aus einer dünnen Kupferschicht hergestellt, die entsprechend dem Layout der elektronischen Schaltung geätzt wird. Die elektrisch leitfähigen Leiterbahnen können sich auf einer oder beiden Seiten der Leiterplatte befinden. Darüber hinaus sind auch Mehrlagenleiterplatten bekannt, bei denen auch Leiterbahnen innerhalb des elektrisch isolierenden Materials der Leiterplatte integriert verlaufen.

Bei hohen Stromstärken im Bereich der Leistungselektronik können elektronische Bauteile über Hochstromverbinder angeschlossen werden. Die Bestückung bzw. Montage derartiger elektrisch leitfähiger Hochstromverbinder stellt allerdings eine Herausforderung dar, da bei der Montage der Hochstromverbinder an der elektrischen Leiterplatte hohe mechanische Kräfte auftreten können, welche zu einer Beschädigung der Leiterplatte führen können. Da die Leiterplatten typischerweise aus einem relativ spröden Material bestehen, kann es selbst bei geringen Montagekräften zu einer teilweisen Beschädigung der Leiterplatten kommen. Weiterhin werden Hochstromverbinder in vielen Fällen an elektrische Kontakte der Leiterbahnen angelötet. Dies kann zu fehlerhaften Lötverbindungen führen. Darüber kann bei Auftreten hoher Temperaturen an der Kontaktstelle das dortige Lot teilweise schmelzen, so dass die Lotverbindung unterbrochen wird.

Das Dokument EP 3 435 490 A1 offenbart eine Stromverbindungsvorrichtung für eine Leiterplatte nach dem Oberbegriff des Anspruchs 1.

Es ist daher eine Aufgabe der vorliegenden Erfindung, eine Stromverbindungsvorrichtung für eine Leiterplatte zu schaffen, welche in einfacher Weise an der Leiterplatte montiert werden kann, ohne dass die Leiterplatte beschädigt wird und welche auch bei auftretenden Temperaturschwankungen stets eine zuverlässige elektrische Verbindung bietet.

Diese Aufgabe wird erfindungsgemäß durch eine Stromverbindungsvorrichtung für eine Leiterplatte mit den in Patentanspruch 1 angegebenen Merkmalen und durch ein Verfahren zur Montage einer derartigen Stromverbindungsvorrichtung an einer Leiterplatte mit den in Patentanspruch 14 angegebenen Merkmalen gelöst.

Die Erfindung schafft demnach eine Stromverbindungsvorrichtung für eine Leiterplatte mit einem ersten Verbindungselement, das eine äußere Kontaktfläche, welche in eine entsprechende Kontaktöffnung der Leiterplatte einsetzbar ist, und eine innere Gleitfläche aufweist, und mit einem zweiten Verbindungselement, das einen dornförmigen Abschnitt mit einer äußeren Gleitfläche aufweist, welche die innere Gleitfläche des in die Kontaktöffnung der Leiterplatte eingesetzten ersten Verbindungselementes nach außen zur Herstellung eines elektrischen Kontaktes zwischen der Kontaktfläche des ersten Verbindungselementes und der Kontaktöffnung der Leiterplatte drückt, sobald die äußere Gleitfläche des dornförmigen Abschnittes des zweiten Verbindungselementes gegen die innere Gleitfläche des ersten gepresst wird.

Die Pressung wird erreicht, weil in einem unverbauten Zustand der Stromverbindungsvorrichtung ein Außenmaß, insbesondere ein Außendurchmesser, des Dorns bzw. des dornförmigen Abschnittes des zweiten Verbindungselementes größer ist als ein Innenmaß, insbesondere ein Innendurchmesser, des ersten Verbindungselementes, das insbesondere als Ring ausgebildet sein kann.

Selbst wenn das zweite Verbindungselement mit hohen mechanischen Kräften in das erste Verbindungselement gepresst wird, kommt es aufgrund der Gleitflächen nur zu sehr geringfügigen mechanischen Verspannungen innerhalb der Leiterplatte, sodass die Gefahr einer Beschädigung der Leiterplatte gering ist. Ein Vorteil der erfindungsgemäßen Stromverbindungsvorrichtung besteht darin, dass sie in einfacher Weise und schnell an der Leiterplatte montiert werden kann. Hierdurch wird der Montageprozess bei der Bestückung der Leiterplatte beschleunigt. Die notwendige Bestückungszeit zur Bestückung einer Leiterplatte kann hierdurch erheblich reduziert werden.

Da keine Beschädigung der Leiterplatte durch die Montage der Stromverbindungsvorrichtung erfolgt, ist zudem der Anteil von beschädigten Leiterplatten bzw. ein Ausschuss nach dem Bestückungsprozess geringer.

Ein weiterer Vorteil besteht darin, dass kein Lötmaterial oder dergleichen zur Herstellung einer elektrischen Verbindung benötigt wird. Zudem besteht die elektrische Verbindung selbst bei hohen Temperaturen weiter, da kein Lötmaterial schmelzen kann.

Bei der erfindungsgemäßen Stromverbindungsvorrichtung ist zwischen dem dornförmigen Abschnitt des zweiten Verbindungselementes und dem ersten Verbindungselement eine Sollbruchverbindung, angeordnet, welche aufbricht, sobald der dornförmige Abschnitt des zweiten Verbindungselementes in das erste Verbindungselement gepresst wird.

Bei einer weiteren möglichen Ausführungsform der erfindungsgemäßen Stromverbindungsvorrichtung weisen die beiden Verbindungselemente der Stromverbindungsvorrichtung ein elektrisch leitfähiges Material, insbesondere eine Metalllegierung, auf. Bei einer weiteren möglichen Ausführungsform der erfindungsgemäßen Stromverbindungsvorrichtung ist der dornförmige Abschnitt des zweiten Verbindungselementes verformbar ausgebildet.

Bei einer möglichen Ausführungsform der erfindungsgemäßen Stromverbindungsvorrichtung ist der dornförmige Abschnitt des zweiten Verbindungselementes elasto-plastisch verformbar.

Bei einer weiteren möglichen Ausführungsform der erfindungsgemäßen Stromverbindungsvorrichtung weist das zweite Verbindungselement einen Anschlussabschnitt auf.

Bei einer möglichen Ausführungsform der erfindungsgemäßen Stromverbindungsvorrichtung ist der Anschlussabschnitt des zweiten Verbindungselementes im Wesentlichen starr ausgebildet.

Im Gegensatz zu dem dornförmigen Abschnitt des zweiten Verbindungselementes ist somit der Anschlussabschnitt bzw. das Anschlusselement bei einer möglichen Ausführungsform im Wesentlichen starr ausgebildet.

Bei einer weiteren möglichen Ausführungsform der erfindungsgemäßen Stromverbindungsvorrichtung ist das erste Verbindungselement verformbar ausgebildet.

Bei einer möglichen Ausführungsform der erfindungsgemäßen Stromverbindungsvorrichtung ist das erste Verbindungselement elasto-plastisch verformbar ausgebildet.

Bei einer weiteren möglichen Ausführungsform der erfindungsgemäßen Stromverbindungsvorrichtung wird das erste Verbindungselement durch einen in die Kontaktöffnung der Leiterplatte einsetzbaren Ring gebildet, welcher eine äußere zylindrische Kontaktfläche und eine nach innen gewölbte Gleitfläche aufweist.

Bei einer weiteren möglichen Ausführungsform der erfindungsgemäßen Stromverbindungsvorrichtung weist der dornförmige Abschnitt des zweiten Verbindungselementes eine nach außen gewölbte Gleitfläche auf.

Bei einer weiteren möglichen Ausführungsform der erfindungsgemäßen Stromverbindungsvorrichtung wird das in die Kontaktöffnung der Leiterplatte eingesetzte erste Verbindungselement der Stromverbindungsvorrichtung zur Herstellung des elektrischen Kontaktes zwischen der Kontaktfläche des ersten Verbindungselementes und der Kontaktöffnung der Leiterplatte vorwiegend elastisch ausgeweitet, sobald die äußere Gleitfläche des dornförmigen Abschnittes des zweiten Verbindungselementes in die innere Gleitfläche des ersten Verbindungselementes gepresst wird.

Bei einer weiteren möglichen Ausführungsform der erfindungsgemäßen Stromverbindungsvorrichtung ist das vorwiegend elastisch ausgeweitete erste Verbindungselement in der Kontaktöffnung der Leiterplatte hinsichtlich weiterer Montageschritte durch Kraft- und/oder Formschluss verdrehsicher angeordnet.

Bei einer weiteren möglichen Ausführungsform der erfindungsgemäßen Stromverbindungsvorrichtung weist das zweite Verbindungselement der Stromverbindungsvorrichtung als Anschlussabschnitt bzw. Anschlusselement eine zylindrische Innenbohrung zum Einführen oder Einschrauben eines elektrischen Steckers auf.

Bei einer weiteren möglichen Ausführungsform der erfindungsgemäßen Stromverbindungsvorrichtung weist die Leiterplatte eine Schicht mit elektrischen Leiterbahnen auf, die mit der Kontaktöffnung der Leiterplatte elektrisch verbunden sind.

Bei einer weiteren möglichen Ausführungsform der erfindungsgemäßen Stromverbindungsvorrichtung ist das zweite Verbindungselement der Stromverbindungsvorrichtung aus dem ersten Verbindungselement der Stromverbindungsvorrichtung zur Unterbrechung des elektrischen Kontaktes zwischen der Kontaktfläche des ersten Verbindungselementes und der Kontaktöffnung der Leiterplatte herausziehbar oder herauspressbar.

Die Erfindung schafft ferner eine Leiterplatte mit den in Patentanspruch 13 angegebenen Merkmalen.

Die Erfindung schafft demnach eine Leiterplatte mit mindestens einer Kontaktöffnung, in die eine Stromverbindungsvorrichtung gemäß dem ersten Aspekt der Erfindung zur Herstellung eines elektrischen Kontaktes eingepresst ist.

Die Erfindung schafft ferner ein Montageverfahren mit den in Patentanspruch 13 angegebenen Merkmalen.

Die Erfindung schafft demnach ein Verfahren zur Montage einer Stromverbindungsvorrichtung gemäß dem ersten Aspekt der Erfindung an einer Leiterplatte mit den Schritten:
Einsetzen des ersten Verbindungselementes der Stromverbindungsvorrichtung in eine Kontaktöffnung einer Leiterplatte, wobei das erste Verbindungselement der Stromverbindungsvorrichtung durch ein Montagehilfselement gestützt wird, und Pressen des zweiten Verbindungselementes der Stromverbindungsvorrichtung gegen das erste Verbindungselement der Stromverbindungsvorrichtung, sodass sich die beiden Verbindungselemente der Stromverbindungsvorrichtung gegeneinander verschieben und die äußere Kontaktfläche des ersten Verbindungselementes gegen die Kontaktfläche der Kontaktöffnung der Leiterplatte zur Herstellung eines elektrischen Kontaktes gedrückt wird, wobei zwischen dem dornförmigen Abschnitt des zweiten Verbindungselementes und dem ersten Verbindungselement eine Sollbruchverbindung angeordnet ist, welche aufbricht, sobald der dornförmige Abschnitt des zweiten Verbindungselements in das erste Verbindungselement gepresst wird.

Bei einer bevorzugten Ausführungsform des erfindungsgemäßen Montageverfahrens ist die Leiterplatte während der Montage der Stromverbindungsvorrichtung im Wesentlichen horizontal ausgerichtet.

Dabei wird das erste Verbindungselement der Stromverbindungsvorrichtung vorzugsweise von oben in eine Kontaktöffnung der im Wesentlichen horizontal ausgerichteten Leiterplatte eingesetzt, wobei das erste Verbindungselement der Stromverbindungsvorrichtung von unten durch ein Montagehilfselement gestützt wird.

Weiterhin wird vorzugsweise das zweite Verbindungselement der Stromverbindungsvorrichtung anschließend von oben gegen das erste Verbindungselement der Stromverbindungsvorrichtung gepresst, sodass sich die beiden Verbindungselemente der Stromverbindungsvorrichtung gegeneinander verschieben und die äu-ßere Kontaktfläche des ersten Verbindungselementes gegen die Kontaktöffnung der Leiterplatte zur Herstellung eines elektrischen Kontaktes gedrückt wird.

Im Weiteren werden mögliche Ausführungsformen der erfindungsmäßen Stromverbindungsvorrichtung und des erfindungsgemäßen Verfahrens unter Bezugnahme auf die beigefügten Figuren detailliert beschrieben.

Es zeigen:
- Figuren 1A, 1B, 1C, 1D: eine Ansicht auf einen Montagevorgang zur Montage einer erfindungsgemäßen Hochstromverbindung an einer Leiterplatte;
- Figuren 2A, 2B, 2C, 2D: Schnittansichten zur Erläuterung des in den Figuren 1A bis 1D dargestellten Montagevorganges;
- Figuren 3A, 3B: gezoomte Detailansichten zur Erläuterung des erfindungsgemäßen Montagevorganges zur Montage einer erfindungsgemäßen Hochstromverbindung an einer Leiterplatte;
- Fig. 4: ein einfaches Ablaufdiagramm zur Darstellung einer möglichen Ausführungsform eines erfindungsgemäßen Montageverfahrens zur Montage einer Stromverbindungsvorrichtung an einer Leiterplatte.

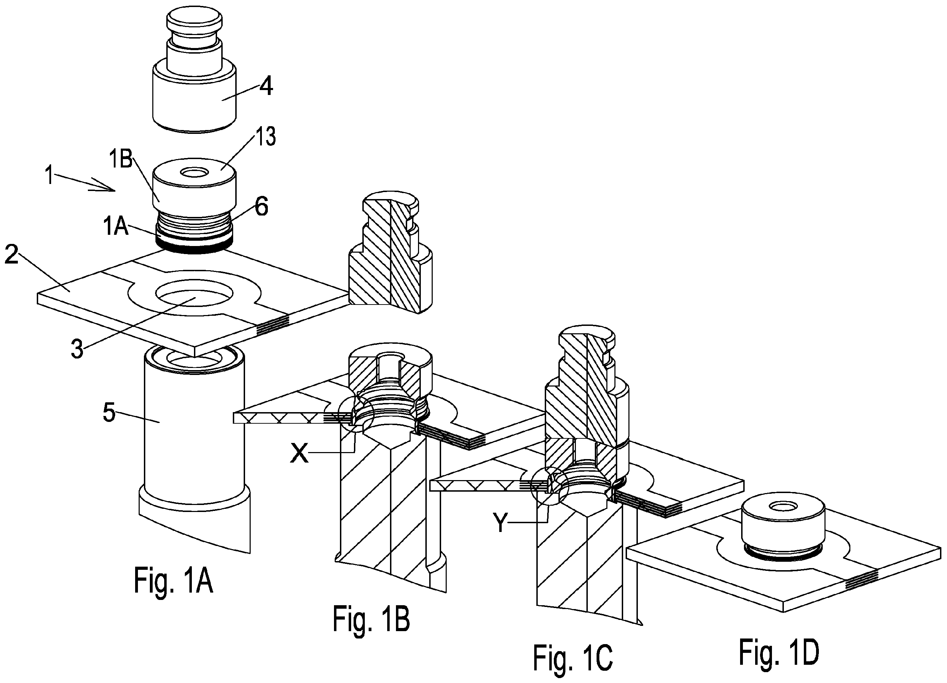

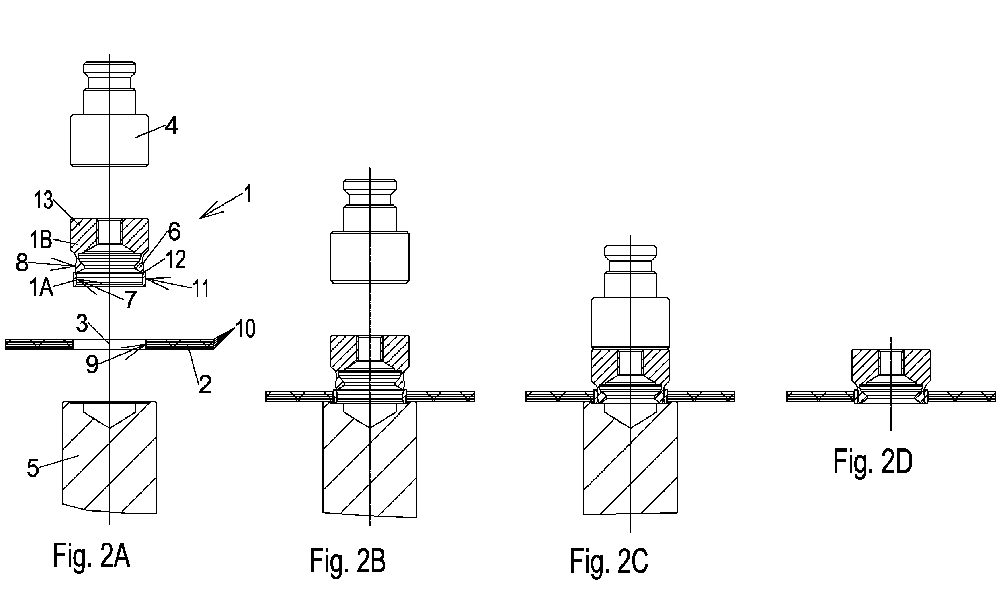

Die perspektivischen Ansichten gemäß Figuren 1A bis 1D sowie die Schnittansichten gemäß Figuren 2A bis 2D zeigen eine Montage einer erfindungsgemäßen Stromverbindungsvorrichtung 1 an einer Leiterplatte 2. Bei dem in den Figuren 1A bis 1D und den Schnittansichten gemäß Figuren 2A bis 2D dargestellten Montagevorgang ist die Leiterplatte 2 im Wesentlichen horizontal ausgerichtet. Alternativ kann die Leiterplatte 2 auch bei einer Montage in einer anderen Richtung ausgerichtet sein, beispielsweise vertikal. Die Leiterplatte 2 besitzt in dem dargestellten Beispiel eine Kontaktöffnung 3, in welche die erfindungsgemäße Stromverbindungsvorrichtung 1 als Bauelement zunächst eingesetzt und anschließend gegen die Kontaktöffnung gepresst wird. Hierzu kann bei einer möglichen Ausführungsform ein Montagepresselement 4 sowie ein Montagehilfselement 5 verwendet werden. Die Stromverbindungsvorrichtung 1 besteht bei dem in den Figuren 1, 2 dargestellten Ausführungsbeispiel aus einem integralen Bauelement, welches aus einem ersten Verbindungselement 1A und einem zweiten Verbindungselement 1B besteht. Die Stromverbindungsvorrichtung 1 weist ein erstes Verbindungselement 1A auf, welches in die entsprechende Kontaktöffnung 3 der Leiterplatte 2 einsetzbar ist. Die Stromverbindungsvorrichtung 1 weist ferner ein zweites Verbindungselement 1B auf, das einen dornförmigen Abschnitt 6 hat. Bei dem in den Figuren 1, 2 dargestellten Beispiel ist das erste Verbindungselement 1A unterhalb des zweiten Verbindungselementes 1B vorgesehen und kann in die Kontaktöffnung 3 der Leiterplatte 2 eingesetzt werden. Bei dem in den Figuren 1, 2 dargestellten Beispiel bilden das erste Verbindungselement 1A und das zweite Verbindungselement 1B zusammen ein integrales Bauelement, nämlich die erfindungsgemäße Stromverbindungsvorrichtung 1. Bei dieser Ausführungsform besteht zwischen dem dornförmigen Abschnitt 6 des oberen zweiten Verbindungselementes 1B und dem unteren in die Kontaktöffnung 3 einsetzbaren ersten Verbindungselement 1A eine Sollbruchverbindung, die erst während des Montagevorganges aufbricht. Bei einer alternativen Ausführungsform können das erste Verbindungselement 1A und das zweite Verbindungselement 1B auch über eine lösbare Verbindung miteinander verbunden sein. Beispielsweise kann an den dornförmigen Abschnitt 6 des zweiten Verbindungselementes 1B ein Ring aufgepresst werden.

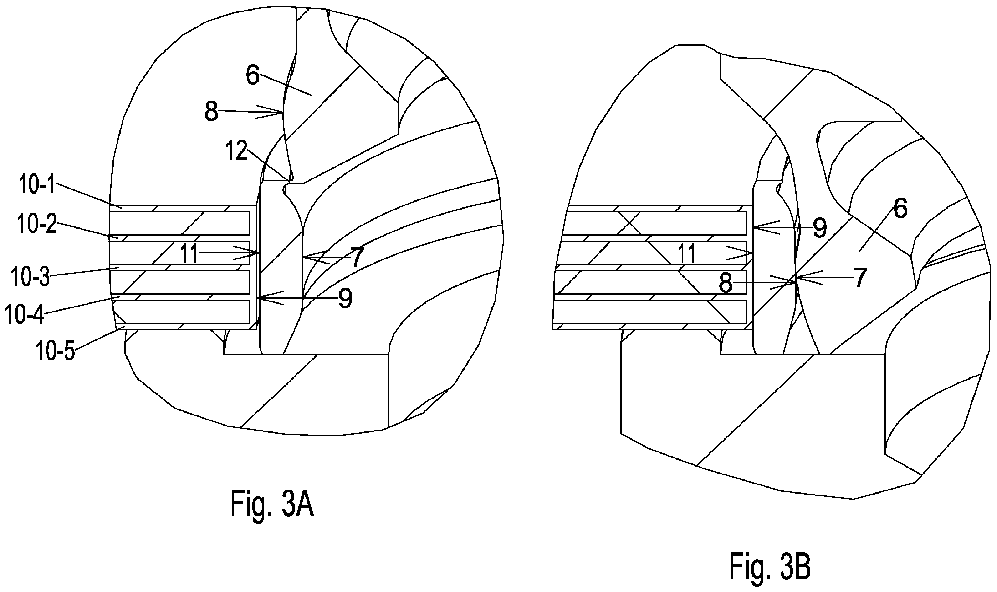

Die Figuren 3A, 3B zeigen detaillierte Schnittansichten zur Darstellung des Montagevorganges. Dabei zeigt Fig. 3A das mit "X" gekennzeichnete Detail aus Fig. 1B und zeigt Fig. 3B das mit "Y" gekennzeichnete Detail aus Fig. 1C, jeweils in gezoomter Darstellung. Man erkennt in den Figuren 3A, 3B oben das zweite Verbindungselement 1B, welches über einen dornförmigen Abschnitt 6 verfügt. Das in die Kontaktöffnung 3 der Leiterplatte 2 eingesetzte erste Verbindungselement 1A weist eine innere Gleitfläche 7 auf. Das zweite Verbindungselement 1B weist einen dornförmigen Abschnitt 6 mit einer äußeren Gleitfläche 8 auf. Die äußere Gleitfläche 8 des dornförmigen Abschnittes 6 des zweiten Verbindungselementes 1B drückt die innere Gleitfläche 7 des in die Kontaktöffnung 3 der Leiterplatte 2 eingesetzten ersten Verbindungselementes 1A nach au-ßen zur Herstellung eines elektrischen Kontaktes zwischen der Kontaktfläche 11 des ersten Verbindungselementes 1A und einer Kontaktfläche 9 der Kontaktöffnung 3 der Leiterplatte 2, sobald die äußere Gleitfläche 8 des dornförmigen Abschnittes 6 des zweiten Verbindungselementes 1B gegen die innere Gleitfläche 7 des ersten Verbindungselementes 1A mechanisch gepresst wird. Bei dem in den Figuren 3A, 3B dargestellten Ausführungsbeispiel ist die Leiterplatte 2 eine mehrlagige Leiterplatte, welche neben den elektrisch leitfähigen Leiterbahnen 10-1, 10-5 auf der Ober- und/oder Unterseite auch innerhalb des isolierenden Materials Leiterbahnen 10-2, 10-3, 10-4 aufweist. An der Kontaktöffnung 3 weist die Leiterplatte 2 eine elektrisch leitfähige Kontaktfläche 9 auf, die elektrisch mit Leiterbahnen 10-1, 10-2, 10-3, 10-4, 10-5 verbunden ist. Bei der in den Figuren 3A, 3B dargestellten Mehrlagenleiterplatte 2 sind somit zwei oder mehr Lagen von Leiterbahnen 10 elektrisch parallel geschaltet, um einen notwendigen Leitungsquerschnitt auch für hohe Stromamplituden zu erreichen. Hierdurch können elektrische Ströme mit höheren Stromamplituden von mehr als 10 Ampere geleitet werden. Die elektrisch leitfähigen Leiterbahnen 10 bzw. Leiterschichten können beispielsweise aus Kupfer bestehen. Durch die Parallelschaltung der elektrischen Leiterbahnen 10 kann zudem bei gegebener Stromstärke der individuelle Querschnitt der verschiedenen Leiterbahnen 10 verringert werden. Die Größe der Leiterplatte 2 kann damit reduziert werden und an gegebene Anforderungen der elektrischen Schaltung, wie beispielsweise größere Spannungsabstände, angepasst werden. Die Anzahl der Leiterbahnen 10 kann je nach Anwendungsfall variieren. Die beiden Verbindungselemente 1A, 1B der Stromverbindungsvorrichtung 1 weisen vorzugsweise ein elektrisch leitfähiges Material auf, insbesondere eine Metalllegierung. Damit kann der elektrische Strom über die beiden Verbindungselemente 1A, 1B der Stromverbindungsvorrichtung 1 und über die elektrisch leitfähige Kontaktfläche 9 an die Leiterbahnen 10 der Leiterplatte 2 fließen. Wie man in Fig. 3A erkennen kann, weist das in die Kontaktöffnung 3 der Leiterplatte 2 eingesetzte erste Verbindungselement 1A eine äußere Kontaktfläche 11 auf, welche gegen die Kontaktfläche 9 der Leiterplatte 2 nach erfolgtem Montagevorgang mechanisch gepresst wird. Die äußere Gleitfläche 8 des dornförmigen Abschnittes 6 des zweiten Verbindungselementes 1B drückt die innere Gleitfläche 7 des in die Kontaktöffnung 3 der Leiterplatte 2 eingesetzten ersten Verbindungselementes 1A nach außen, sodass die äußere Kontaktfläche 11 des ersten Verbindungselementes 1A nach außen zur Herstellung eines elektrischen Kontaktes zwischen der Kontaktfläche 11 und der Kontaktfläche 9 der Leiterplatte 2 gedrückt wird. Dies ist in Fig. 3B dargestellt, in welcher der eingeführte dornförmige Abschnitt 6 des zweiten Verbindungselementes 1B die elektrisch leitfähige Kontaktfläche 11 des ersten Verbindungselementes 1A gegen die Kontaktfläche 9 der Kontaktöffnung 3 der Leiterplatte 2 mechanisch drückt. Aufgrund der mechanischen Kraft ist der elektrische Übergangswiderstand zwischen der Kontaktfläche 9 der Leiterplatte 2 und der Kontaktfläche 11 des ersten Verbindungselementes 1A gering.

Bei einer möglichen Ausführungsform ist das erste Verbindungselement 1A und das zweite Verbindungselement 1B der Stromverbindungsvorrichtung 1 über eine Sollbruchverbindung 12 zunächst verbunden. Diese Sollbruchstelle bzw. Sollbruchverbindung 12 bricht während des Montagevorganges auf, sobald der dornförmige Abschnitt 6 des zweiten Verbindungselementes 1B in das erste Verbindungselement 1A gepresst wird, wie auch in Fig. 3B dargestellt. Alternativ kann das erste Verbindungselement 1A auch über eine lösbare Verbindung mit dem zweiten Verbindungselement 1B verbunden sein. Fig. 3A zeigt den Zustand der Stromverbindungsvorrichtung 1 nach Einsetzen des ersten Verbindungselementes 1A in die Kontaktöffnung 3 der Leiterplatte 2, bevor das zweite Verbindungselement 1B nach unten mithilfe eines Presselementes bzw. Montagepresselement 4 gepresst wird. Fig. 3B zeigt den Zustand nach Einpressen des zweiten Verbindungselementes 1B in das erste Verbindungselement 1A. Der dornförmige Abschnitt 6 des zweiten Verbindungselementes 1B ist vorzugsweise verformbar. Beispielsweise kann der dornförmige Abschnitt 6 des zweiten Verbindungselementes 1B elasto-plastisch verformbar ausgebildet sein. Bei dem Einpressvorgang findet häufig anfänglich eine elastische Verformung statt, welche anschließend in eine plastische Verformung übergeht.

Das erste Verbindungselement 1A ist vorzugsweise ebenfalls verformbar. Beispielsweise ist das erste Verbindungselement 1A elasto-plastisch verformbar ausgebildet.

Bei dem in den Figuren 1, 2 dargestellten Ausführungsbeispiel ist die Kontaktöffnung 3 der Leiterplatte 2 kreisförmig ausgebildet. Bei alternativen Ausführungsformen kann die Kontaktöffnung 3 der Leiterplatte 2 auch einen anderen Querschnitt aufweisen, beispielsweise quadratisch, dreieckig, elliptisch oder rechteckig. Bei diesen Ausführungsformen ist das erste Verbindungselement 1A entsprechend geformt bzw. ausgebildet, d.h. beispielsweise dreieckig, quadratisch, rechteckig oder elliptisch. Das in die Kontaktöffnung 3 der Leiterplatte 2 eingesetzte erste Verbindungselement 1A der Stromverbindungsvorrichtung 1 wird zur Herstellung des elektrischen Kontaktes zwischen der Kontaktfläche 11 des ersten Verbindungselementes 1A und der Kontaktfläche 9 der Kontaktöffnung 3 der Leiterplatte 2 vorzugsweise vorwiegend elastisch ausgeweitet, sobald die äußere Gleitfläche 8 des dornförmigen Abschnittes 6 des zweiten Verbindungselementes 1B gegen die innere Gleitfläche 7 des ersten Verbindungselementes 1A gepresst wird. Das vorzugsweise vorwiegend elastisch ausgeweitete erste Verbindungselement 1A ist in der Kontaktöffnung 3 der Leiterplatte 2 hinsichtlich weiterer Montageschritte durch Kraft- und/oder Formschluss verdrehsicher angeordnet.

Das zweite Verbindungselement 1B der Stromverbindungsvorrichtung 1 weist bei einer bevorzugten Ausführungsform einen Anschlussabschnitt 13 auf. Dieser Anschlussabschnitt 13 weist bei einer möglichen Ausführungsform eine zylindrische Innenbohrung auf. Diese zylindrische Innenbohrung dient bei einer möglichen Ausführungsform zum Einführen oder Einschrauben eines elektrischen Steckers zum Leiten eines elektrischen Stromes, insbesondere eines elektrischen Stromes mit mehr als 10 Ampere.

Die Figuren 1, 2 zeigen die Montage der erfindungsmäßen Stromverbindungsvorrichtung 1 an einer Leiterplatte 2. Zunächst wird die Stromverbindungsvorrichtung 1 in die Kontaktöffnung 3 der Leiterplatte 2 eingesetzt, wie in den Figu-ren 1B, 2B dargestellt. Die Leiterplatte 2 ist dabei vorzugsweise horizontal ausgerichtet. Die eingesetzte Stromverbindungsvorrichtung 1 wird von unten durch ein Montagehilfselement 5 gestützt, wie unter anderem in den Figuren 1B, 2B dargestellt. Anschließend wird von oben ein Presselement bzw. Montagepresselement 4 nach unten geführt und presst das zweite Verbindungselement 1B der Stromverbindungsvorrichtung 1 gegen das untere erste Verbindungselement 1A der Stromverbindungsvorrichtung 1, sodass sich die beiden Verbindungselemente 1A, 1B der Stromverbindungsvorrichtung 1 gegeneinander räumlich vertikal verschieben und die äußere Kontaktfläche 11 des ersten Verbindungselementes 1A gegen die Kontaktfläche 9 der Kontaktöffnung 3 der Leiterplatte 2 zur Herstellung eines elektrischen Kontaktes drücken. Die Figuren 1C, 2C zeigen das Pressen des zweiten Verbindungselementes 1B gegen das darunterliegende Verbindungselement 1A, welches durch das Montagehilfselement 5 gestützt wird. Die Figuren 1D, 2D zeigen die in der Leiterplatte 2 montierte Stromverbindungsvorrichtung 1 mit der nach oben gerichteten zylindrischen Innenbohrung 13 zum Einführen oder Einschrauben eines elektrischen Steckers.

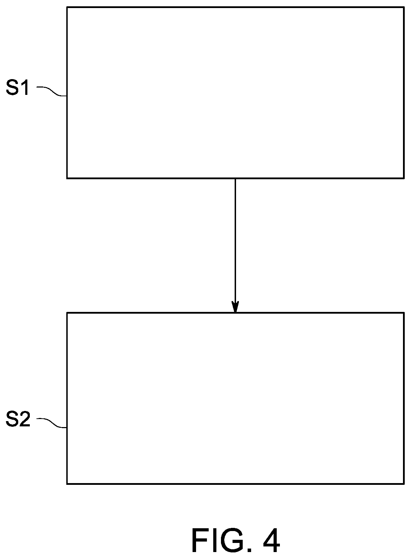

Fig. 4 zeigt ein einfaches Ablaufdiagramm zur Darstellung des erfindungsgemäßen Verfahrens zur Montage einer Stromverbindungsvorrichtung 1 einer Leiterplatte 2.

In einem ersten Montageschritt S1 wird das erste Verbindungselement 1A der Stromverbindungsvorrichtung 1 in eine Kontaktöffnung 3 einer Leiterplatte 2 eingesetzt, wobei das erste Verbindungselement 1A der Stromverbindungsvorrichtung 1 vorzugsweise durch ein Montagehilfselement 5 gestützt wird. Vorzugsweise erfolgt das Einsetzen des ersten Verbindungselementes 1A der Stromverbindungsvorrichtung 1 von oben in eine Kontaktöffnung 3 einer im Wesentlichen horizontal ausgerichteten Leiterplatte 2, wie in den Figuren 1, 2 dargestellt. Das erste Verbindungselement 1A der Stromverbindungsvorrichtung 1 wird dabei von unten durch das Montagehilfselement 5 gestützt.

Anschließend wird in einem zweiten Montageschritt S2 das zweite Verbindungselement 1B der Stromverbindungsvorrichtung 1 gegen das erste Verbindungselement 1A der Stromverbindungsvorrichtung 1 gepresst, sodass sich die beiden Verbindungselemente 1A, 1B der Stromverbindungsvorrichtung 1 gegeneinander räumlich in vertikaler Richtung, d.h. senkrecht zur Ausrichtung der Leiterplatte 2, verschieben und die äußere Kontaktfläche 11 des ersten Verbindungselementes 1A gegen die Kontaktfläche 9 der Kontaktöffnung 3 der Leiterplatte 2 zur Herstellung eines elektrischen Kontaktes gedrückt wird. Vorzugsweise wird das zweite Verbindungselement 1B von oben in das erste Verbindungselement 1A der Stromverbindungsvorrichtung 1 gepresst, wie in den Figuren 1, 2 dargestellt.

Bei einer möglichen Ausführungsform befindet sich das Montagehilfselement 5 auf einem Montagetisch einer Montagevorrichtung. Bei einer möglichen Ausführungsform weist die Leiterplatte 2 eine Vielzahl von entsprechenden Kontaktöffnungen 3 auf, wobei für jede Kontaktöffnung 3 ein entsprechendes Montagehilfselement 5 auf dem Montagetisch montierbar vorgesehen ist. Die Form und Anzahl der Kontaktöffnungen 3 kann je nach Anwendungsfall variieren.

Bei einer möglichen Ausführungsform kann die montierte Stromverbindungsvorrichtung 1 auch wieder aus der Kontaktöffnung 3 der Leiterplatte 2 entfernt werden. Bei einer möglichen Ausführungsform ist das zweite Verbindungselement 1B der Stromverbindungsvorrichtung 1 aus dem ersten Verbindungselement 1A der Stromverbindungsvorrichtung 1 zur Unterbrechung des elektrischen Kontaktes zwischen der Kontaktfläche des ersten Verbindungselementes 1A und der Kontaktfläche der Kontaktöffnung 3 der Leiterplatte 2 herausziehbar oder herauspressbar.

Die Stromverbindungsvorrichtung 1 kann bei einer möglichen Ausführungsform über ein oder mehrere Anschlussabschnitte 13 verfügen. Vorzugsweise ist an dem zweiten Verbindungselement 1B ein Anschlussabschnitt 13 in Form einer zylindrischen Innenbohrung vorgesehen. Bei einer möglichen Ausführungsform ist auch an dem weiteren ersten Verbindungselement 1A ein Anschlussabschnitt 13 vorgesehen, beispielsweise eine zylindrische Innenbohrung zum Einführen oder Einschrauben eines elektrischen Steckers. Bei einer weiteren möglichen Ausführungsform ist sowohl an dem zweiten Verbindungselement 1B als auch an dem ersten Verbindungselement 1A ein entsprechender Anschlussabschnitt 13 vorgesehen. Beispielsweise kann der Anschlussabschnitt 13 ein M5-Gewinde aufweisen.

Bei einer möglichen Ausführungsform der erfindungsgemäßen Stromverbindungsvorrichtung 1 ist sowohl das erste Verbindungselement 1A als auch das zweite Verbindungselement 1B rotationssymmetrisch, das bedeutet in diesem Zusammenhang als Rotationskörper, ausgebildet. Bei dieser Ausführungsform kann die Stromverbindungsvorrichtung 1 beispielsweise in einem Drehprozess hergestellt werden.

Bei einer alternativen Ausführungsform kann das erste und/oder das zweite Verbindungselement 1A, 1B aber auch elliptisch oder quadratisch ausgebildet sein, wobei bei dieser Ausführungsform die Stromverbindungsvorrichtung 1 beispielsweise in einem Fräsvorgang hergestellt werden kann. Beispielsweise kann durch einen quadratischen Querschnitt des in eine entsprechende quadratische Kontaktöffnung eingesetzten ersten Verbindungselementes 1A eine einfache formschlüssige verdrehsichere Verbindung erreicht werden. Das ausgeweitete erste Verbindungselement 1A ist in der Kontaktöffnung 3 der Leiterplatte 2 hinsichtlich weiterer Montageschritte durch Kraft- und/oder Formschluss verdrehsicher angeordnet.

Die Gleitflächen sind vorzugsweise derart geformt, dass während des Montagevorganges keine zu hohen Verspannkräfte in der Leiterplatte 2 entstehen. Bei einer möglichen Ausführungsform wird das erste Verbindungselement 1A der Stromverbindungsvorrichtung 1 durch einen in die Kontaktöffnung 3 der Leiterplatte 2 einsetzbaren Ring gebildet, welcher eine äußere zylindrische Kontaktmantelfläche und eine nach innen gewölbte Gleitfläche aufweist. Der Ring bzw. das erste Verbindungselement 1A kann bei einer möglichen Ausführungsform auch Schlitze aufweisen, um das Einsetzten zu erleichtern und/oder die angestrebte Pressung zwischen dem ersten Verbindungselement 1A und der Kontaktöffnung 3 der Leiterplatte 2 zu erhöhen. Der dornförmige Abschnitt 6 des zweiten Verbindungselementes 1B weist vorzugsweise eine nach außen gewölbte Gleitfläche 8 auf, wie in den Figuren 3A, 3B dargestellt. Der dornförmige Abschnitt 6 und das ringförmige erste Verbindungselement 1A weisen vorzugsweise Gleitzonen bzw. Gleitflächen 7, 8 auf, die gegeneinander fügbar ausgeführt sind. Bei einer möglichen Ausführungsform sind die Gleitflächen 7, 8 bzw. Gleitzonen im Wesentlichen konisch ausgeführt. Die Größe bzw. Dimensionierung der beiden Verbindungselemente 1A, 1B der Stromverbindungsvorrichtung 1 können je nach Anwendungsfall, insbesondere in Abhängigkeit der erforderlichen Stromdichte, variieren. Beispielsweise weist die Stromverbindungsvorrichtung 1 rotationssymmetrische Verbindungselemente auf, welche einen Außendurchmesser von etwa 10 bis 20 mm aufweisen. Die Größe der Kontaktflächen hängt von der Stromstärke bzw. Stromdichte des zu übertragenen elektrischen Stromes ab. Bei einer möglichen Ausführungsform ist die Stromverbindungsvorrichtung 1 dazu ausgelegt, einen elektrischen Strom von mehr als 10 Ampere zu übertragen, beispielsweise einen elektrischen Strom in Höhe von etwa 600 Ampere. Die erfindungsgemäße Stromverbindungsvorrichtung 1 eignet sich sowohl zur Übertragung eines Gleichstromes (DC) als auch zur Stromübertragung eines Wechselstromes (AC). Die erfindungsgemäße Stromverbindungsvorrichtung 1 kann insbesondere für Leiterplatten 2 vorgesehen werden, welche mit Leistungselektronikbauteilen bestückt sind. Weitere Ausführungsformen sind möglich. Beispielsweise kann an der Stromverbindungsvorrichtung 1 auch ein Kühlelement vorgesehen sein. Um die Verdrehsicherheit der montierten Stromverbindungsvorrichtung 1 zu erhöhen, kann zusätzlich an der Außenfläche des ersten Verbindungselementes 1A eine Rändelung vorgesehen sein. Das zweite Verbindungselement 1B kann bei einer möglichen Ausführungsform auch über mehrere Anschlussabschnitte bzw. Anschlusselemente 13 zum Einschrauben oder Einführen von elektrischen Steckern verfügen. Das Gleiche gilt auch für das untere erste Verbindungselement 1A der Stromverbindungsvorrichtung 1.

## Patentansprüche

1. Stromverbindungsvorrichtung (1) für eine Leiterplatte (2) mit
- einem ersten Verbindungselement (1A), das eine äußere Kontaktfläche (11), welche in eine entsprechende Kontaktöffnung (3) der Leiterplatte (2) einsetzbar ist, und eine innere Gleitfläche (7) aufweist, und mit
- einem zweiten Verbindungselement (1B), das einen dornförmigen Abschnitt (6) mit einer äußeren Gleitfläche (8) aufweist, welche die innere Gleitfläche (7) des in die Kontaktöffnung (3) der Leiterplatte (2) eingesetzten ersten Verbindungselementes (1A) nach außen zur Herstellung eines elektrischen Kontaktes zwischen der Kontaktfläche (11) des ersten Verbindungselementes (1A) und einer Kontaktfläche (9) der Kontaktöffnung (3) der Leiterplatte (2) drückt, sobald die äußere Gleitfläche (11) des dornförmigen Abschnittes (6) des zweiten Verbindungselementes (1B) gegen die innere Gleitfläche (7) des ersten Verbindungselementes (1A) gepresst wird,
**dadurch gekennzeichnet, dass** zwischen dem dornförmigen Abschnitt (6) des zweiten Verbindungselementes (1B) und dem ersten Verbindungselement (1A) eine Sollbruchverbindung (12) angeordnet ist, welche aufbricht, sobald der dornförmige Abschnitt (6) des zweiten Verbindungselements (1B) in das erste Verbindungselement (1A) gepresst wird.

2. Stromverbindungsvorrichtung nach Anspruch 1 ,
wobei die beiden Verbindungselemente (1A, 1B) der Stromverbindungsvorrichtung (1) ein elektrisch leitfähiges Material, insbesondere eine Metalllegierung, aufweisen und/oder
wobei der dornförmige Abschnitt (6) des zweiten Verbindungselementes (1B) verformbar, insbesondere elasto-plastisch verformbar, ausgebildet ist.

3. Stromverbindungsvorrichtung nach einem der vorangehenden Ansprüche 1 oder 2,
wobei das erste Verbindungselement (1A) und/oder das zweite Verbindungselement (1B) einen Anschlussabschnitt (13) aufweist.

4. Stromverbindungsvorrichtung nach Anspruch 3,
wobei der Anschlussabschnitt (13) im Wesentlichen starr ausgebildet ist.

5. Stromverbindungsvorrichtung nach einem der vorangehenden Ansprüche 1 bis 4,
wobei das erste Verbindungselement (1A) verformbar, insbesondere elasto-plastisch verformbar, ausgebildet ist, und/oder
wobei das erste Verbindungselement (1A) durch einen in die Kontaktöffnung (3) der Leiterplatte (2) einsetzbaren Ring gebildet wird, welcher eine äußere zylindrische Kontaktfläche (11) und eine nach innen gewölbte Gleitfläche (7) aufweist.

6. Stromverbindungsvorrichtung nach Anspruch 5,
wobei der Ring geschlitzt ist.

7. Stromverbindungsvorrichtung nach einem der vorangehenden Ansprüche,
wobei der dornförmige Abschnitt (6) des zweiten Verbindungselementes (1B) eine nach außen gewölbte Gleitfläche (8) aufweist.

8. Stromverbindungsvorrichtung nach einem der vorangehenden Ansprüche,
wobei das in die Kontaktöffnung (3) der Leiterplatte (2) eingesetzte erste Verbindungselement (1A) der Stromverbindungsvorrichtung (1) zur Herstellung des elektrischen Kontaktes zwischen der Kontaktfläche (11) des ersten Verbindungselementes (1A) und der Kontaktfläche (9) der Kontaktöffnung (3) der Leiterplatte (2) vorwiegend elastisch ausgeweitet wird, sobald die äußere Gleitfläche (8) des dornförmigen Abschnittes (6) des zweiten Verbindungselementes (1B) gegen die innere Gleitfläche (7) des ersten Verbindungselementes (1A) gepresst wird.

9. Stromverbindungsvorrichtung nach Anspruch 8,
wobei das ausgeweitete erste Verbindungselement (1A) in der Kontaktöffnung (3) der Leiterplatte (2) hinsichtlich weiterer Montageschritte durch Kraft- und/oder Formschluss verdrehsicher angeordnet ist.

10. Stromverbindungsvorrichtung nach Anspruch 9,
wobei der Formschluss erreicht wird, indem der dornförmige Abschnitt (6) des zweiten Verbindungselementes (1B) und das erste Verbindungselement (1A) eine von einem Rotationskörper abweichende Form aufweisen.

11. Stromverbindungsvorrichtung nach einem der vorangehenden Ansprüche 3 bis 10,
wobei das zweite Verbindungselement (1B) der Stromverbindungsvorrichtung (1) als einen Anschlussabschnitt (13) eine zylindrische Innenbohrung zum Einführen oder Einschrauben eines elektrischen Steckers aufweist, und/oder wobei die Leiterplatte (2) mindestens eine Schicht mit elektrischen Leiterbahnen (10) aufweist, die mit der Kontaktfläche (9) der Kontaktöffnung (3) der Leiterplatte (2) elektrisch verbunden sind.

12. Stromverbindungsvorrichtung nach einem der vorangehenden Ansprüche,
wobei das zweite Verbindungselement (1B) der Stromverbindungsvorrichtung (1) aus dem ersten Verbindungselement (1A) der Stromverbindungsvorrichtung (1) zur Unterbrechung des elektrischen Kontaktes zwischen der Kontaktfläche (11) des ersten Verbindungselementes (1A) und der Kontaktöffnung (3) der Leiterplatte (2) herausziehbar oder herauspressbar ist.

13. Leiterplatte (2) mit mindestens einer Kontaktöffnung (3), in die eine Stromverbindungsvorrichtung (1) nach einem der vorangehenden Ansprüche 1 bis 12 zur Herstellung eines elektrischen Kontaktes eingepresst ist.

14. Verfahren zur Montage einer Stromverbindungsvorrichtung (1) nach einem der vorangehenden Ansprüche 1 bis 12 an einer Leiterplatte (2) mit den Schritten:
- Einsetzen (S1) des ersten Verbindungselementes (1A) der Stromverbindungsvorrichtung (1) in eine Kontaktöffnung (3) der Leiterplatte (2), wobei das erste Verbindungselement (1A) der Stromverbindungsvorrichtung (1) durch ein Montagehilfselement (5) gestützt wird, und
- Pressen (S2) des zweiten Verbindungselementes (1B) der Stromverbindungsvorrichtung (1) gegen das erste Verbindungselement (1A) der Stromverbindungsvorrichtung (1), sodass sich die beiden Verbindungselemente (1A, 1B) der Stromverbindungsvorrichtung (1) gegeneinander verschieben und die äußere Kontaktfläche (11) des ersten Verbindungselementes (1A) gegen die Kontaktfläche (9) der Kontaktöffnung (3) der Leiterplatte (2) zur Herstellung eines elektrischen Kontaktes gedrückt wird, wobei zwischen dem dornförmigen Abschnitt (6) des zweiten Verbindungselementes (1B) und dem ersten Verbindungselement (1A) eine Sollbruchverbindung (12), angeordnet ist, welche aufbricht, sobald der dornförmige Abschnitt (6) des zweiten Verbin dungselements (1B) in das erste Verbindungselement (1A) gepresst wird.

## Claims

1. A power connection device (1) for a printed circuit board (2) with
- a first connecting element (1A), which has an outer contact surface (11), which can be inserted into a corresponding contact opening (3) of the printed circuit board (2), and an inner sliding surface (7), and with
- a second connecting element (1B) having a thorn-shaped section (6) with an outer sliding surface (8), which presses the inner sliding surface (7) of the first connecting element (1A) inserted into the contact opening (3) of the printed circuit board (2) outwardly to establish an electrical contact between the contact surface (11) of the first connecting element (1A) and a contact surface (9) of the contact opening (3) of the printed circuit board (2), as soon as the outer sliding surface (8) of the thorn-shaped section (6) of the second connecting element (1B) is pressed against the inner sliding surface (7) of the first connecting element (1A),
**characterized in that** a predetermined breaking connection (12) is arranged between the thorn-shaped section (6) of the second connecting element (1B) and the first connecting element (1A), which breaks open as soon as the thorn-shaped section (6) of the second connecting element (1B) is pressed into the first connecting element (1A).

2. The power connection device according to claim 1,
wherein the two connecting elements (1A, 1B) of the power connection device (1) comprise an electrically conductive material, in particular a metal alloy, and/or
wherein the thorn-shaped section (6) of the second connecting element (1B) is designed to be deformable, in particular elasto-plastically deformable.

3. The power connection device according to any of the preceding claims 1 or 2,
wherein the first connecting element (1A) and/or the second connecting element (1B) has a connection section (13).

4. The power connection device according to claim 3,
wherein the connection section (13) is essentially rigid.

5. The power connection device according to any one of the preceding claims 1 to 4,
wherein the first connecting element (1A) is designed to be deformable, in particular elasto-plastically deformable, and/or
wherein the first connecting element (1A) is formed by a ring which can be inserted into the contact opening (3) of the printed circuit board (2) and which has an outer cylindrical contact surface (11) and an inwardly curved sliding surface (7).

6. The power connection device according to claim 5,
wherein the ring is slotted.

7. The power connection device according to any one of the preceding claims,
wherein the thorn-shaped section (6) of the second connecting element (1B) has an outwardly curved sliding surface (8).

8. The power connection device according to any one of the preceding claims,
wherein the first connecting element (1A) of the power connecting device (1) inserted into the contact opening (3) of the printed circuit board (2) is predominantly elastically expanded to establish the electrical contact between the contact surface (11) of the first connecting element (1A) and the contact surface (9) of the contact opening (3) of the printed circuit board (2), as soon as the outer sliding surface (8) of the thorn-shaped section (6) of the second connecting element (1B) is pressed against the inner sliding surface (7) of the first connecting element (1A).

9. The power connection device according to claim 8,
wherein the expanded first connecting element (1A) is arranged in the contact opening (3) of the printed circuit board (2) in such a way that it is torsion-free with respect to further assembly steps by means of force fitting and/or form fitting.

10. The power connection device according to claim 9,
wherein the form fitting is achieved by the thorn-shaped section (6) of the second connecting element (1B) and the first connecting element (1A) having a shape that differs from a body of revolution.

11. The power connection device according to any one of the preceding claims 3 to 10,
wherein the second connecting element (1B) of the power connection device (1) has as a connection section (13) a cylindrical inner bore for inserting or screwing in an electrical plug, and/or wherein the printed circuit board (2) has at least one layer with electrical conductor tracks (10), which are electrically connected to the contact surface (9) of the contact opening (3) of the printed circuit board (2).

12. The power connection device according to any one of the preceding claims,
wherein the second connecting element (1B) of the power connection device (1) can be pulled or pressed out of the first connecting element (1A) of the power connection device (1) for interrupting the electrical contact between the contact surface (11) of the first connecting element (1A) and the contact opening (3) of the printed circuit board (2).

13. A printed circuit board (2) with at least one contact opening (3), into which a power connection device (1) according to one of the preceding claims 1 to 12 is pressed to establish an electrical contact.

14. A method for the assembly of a power connection device (1) according to any one of the preceding claims 1 to 12 on a printed circuit board (2), comprising the steps of:
- Insertion (Sl) of the first connecting element (1A) of the power connection device (1) into a contact opening (3) of the printed circuit board (2), wherein the first connecting element (1A) of the power connection device (1) is supported by an auxiliary mounting element (5), and
- Pressing (S2) of the second connecting element (1B) of the power connection device (1) against the first connecting element (1A) of the power connection device (1), so that the two connecting elements (1A, 1B) of the power connection device (1) are displaced against each other and the outer contact surface (11) of the first connecting element (1A) is pressed against the contact surface (9) of the contact opening (3) of the printed circuit board (2) to establish an electrical contact,
wherein a predetermined breaking connection (12) is arranged between the thorn-shaped section (6) of the second connecting element (1B) and the first connecting element (1A), which breaks open as soon as the thorn-shaped section (6) of the second connecting element (1B) is pressed into the first connecting element (1A).

## Revendications

1. Dispositif de connexion électrique (1) pour une carte à circuit imprimé (2) comportant :
- un premier élément de connexion (1A) comportant une surface de contact extérieure (11) qui peut être insérée dans une ouverture de contact (3) correspondante de la carte à circuit imprimé (2), et une surface de glissement intérieure (7), et
- un second élément de connexion (1B) comportant une partie en forme de mandrin (6) ayant une surface de glissement extérieure (8) qui pousse la surface de glissement intérieure (7) du premier élément de connexion (1A) inséré dans l'ouverture de contact (3) de la carte à circuit imprimé (2) vers l'extérieur pour établir un contact électrique entre la surface de contact (11) du premier élément de connexion (1A) et une surface de contact (9) de l'ouverture de contact (3) de la carte à circuit imprimé (2), dès que la surface de glissement extérieure (11) de la partie en forme de mandrin (6) du second élément de connexion (1B) est pressée contre la surface de glissement intérieure (7) du premier élément de connexion (1A),
**caractérisé en ce qu'**une liaison à rupture programmée (12) est disposée entre la partie en forme de mandrin (6) du second élément de connexion (1B) et le premier élément de connexion (1A) et se rompt dès que la partie en forme de mandrin (6) du second élément de connexion (1B) est pressée dans le premier élément de connexion (1A).

2. Dispositif de connexion électrique selon la revendication 1,
dans lequel les deux éléments de connexion (1A, 1B) du dispositif de connexion électrique (1) comportent un matériau électriquement conducteur, en particulier un alliage métallique, et/ou
dans lequel la partie en forme de mandrin (6) du second élément de connexion (1B) est agencée de manière déformable, en particulier élastiquement déformable.

3. Dispositif de connexion électrique selon l'une des revendications 1 ou 2 précédentes,
dans lequel le premier élément de connexion (1A) et/ou le second élément de connexion (1B) comporte une partie de raccordement (13).

4. Dispositif de connexion électrique selon la revendication 3,
dans lequel la partie de raccordement (13) est agencée de manière essentiellement rigide.

5. Dispositif de connexion électrique selon l'une des revendications 1 à 4 précédentes,
dans lequel le premier élément de connexion (1A) est agencé de manière déformable, en particulier élasto-plastiquement déformable, et/ou
dans lequel le premier élément de connexion (1A) est formé par une bague pouvant être insérée dans l'ouverture de contact (3) de la carte à circuit imprimé (2) et comporte une surface de contact cylindrique extérieure (11) et une surface de glissement (7) bombée vers l'intérieur.

6. Dispositif de connexion électrique selon la revendication 5,
dans lequel la bague est fendue.

7. Dispositif de connexion électrique selon l'une des revendications précédentes,
dans lequel la partie en forme de mandrin (6) du second élément de connexion (1B) comporte une surface de glissement bombée vers l'extérieur (8).

8. Dispositif de connexion électrique selon l'une des revendications précédentes,
dans lequel le premier élément de connexion (1A) du dispositif de connexion électrique (1) inséré dans l'ouverture de contact (3) de la carte à circuit imprimé (2) pour établir le contact électrique entre la surface de contact (11) du premier élément de connexion (1A) et la surface de contact (9) de l'ouverture de contact (3) de la carte à circuit imprimé (2) est élargi de manière principalement élastique dès que la surface de glissement extérieure (8) de la partie en forme de mandrin (6) du second élément de connexion (1B) est pressée contre la surface de glissement intérieure (7) du premier élément de connexion (1A).

9. Dispositif de connexion électrique selon la revendication 8,
dans lequel le premier élément de connexion (1A) élargi dans l'ouverture de contact (3) de la carte à circuit imprimé (2) est disposé de manière bloquée en rotation pour d'autres étapes de montage par assemblage à force et/ou par complémentarité de formes.

10. Dispositif de connexion électrique selon la revendication 9,
dans lequel l'assemblage par complémentarité de formes est réalisé par la partie en forme de mandrin (6) du second élément de connexion (1B) et le premier élément de connexion (1A) qui ont des formes différentes d'un corps rotatif.

11. Dispositif de connexion électrique selon l'une des revendications 3 à 10 précédentes,
dans lequel le second élément de connexion (1B) du dispositif de connexion électrique (1) comporte, en tant que partie de raccordement (13), un alesage intérieur cylindrique pour introduire ou visser une fiche électrique, et/ou
dans lequel la carte à circuit imprimé (2) comporte au moins une couche avec des pistes conductrices électriques (2) qui sont électriquement connectées à la surface de contact (9) de l'ouverture de contact (3) de la carte à circuit imprimé (2).

12. Dispositif de connexion électrique selon l'une des revendications précédentes,
dans lequel le second élément de connexion (1B) du dispositif de connexion électrique (1) peut être extrait ou pressé hors du premier élément de connexion (1A) du dispositif de connexion électrique (1) pour interrompre le contact électrique entre la surface de contact (11) du premier élément de connexion (1A) et l'ouverture de contact (3) de la carte à circuit imprimé (2).

13. Carte à circuit imprimé (2) comportant au moins une ouverture de contact (3) dans laquelle est pressé un dispositif de connexion électrique (1) selon l'une des revendications 1 à 12 précédentes pour établir un contact électrique.

14. Procédé destiné à monter un dispositif de connexion électrique (1) selon l'une des revendications 1 à 6 précédentes sur une carte à circuit imprimé (2), comportant les étapes consistant à :
- insérer (S1) le premier élément de connexion (1A) du dispositif de connexion électrique (1) dans une ouverture de contact (3) de la carte à circuit imprimé (2), dans lequel le premier élément de connexion (1A) du dispositif de connexion électrique (1) est supporté par un élément d'aide au montage (5), et
- presser (S2) le second élément de connexion (1B) du dispositif de connexion électrique (1) contre le premier élément de connexion (1A) du dispositif de connexion électrique (1) de telle sorte que les deux éléments de connexion (1A, 1B) du dispositif de connexion électrique (1) se déplacent l'un contre l'autre et la surface de contact extérieure (11) du premier élément de connexion (1A) est pressée contre la surface de contact (9) de l'ouverture de contact (3) de la carte à circuit imprimé (2) pour établir un contact électrique, dans lequel une liaison à rupture programmée (12) est disposée entre la partie en forme de mandrin (6) du second élément de connexion (1B) et le premier élément de connexion (1A) et se rompt dès que la partie en forme de mandrin (6) du second élément de connexion (1B) est pressée dans le premier élément de connexion (1A).
